# EUROPEAN PATENT APPLICATION

(11) **EP 1 653 519 A1**
(43) Date of publication of application: **03.05.2006**
(21) Application number: 05100851.4
(22) Date of filing: 07.02.2005
(51) Int. Cl.: H01L 31/0224, H01L 31/0216

(54) **Photoelectric conversion device**

(30) Priority: 29.10.2004 JP 2004316446
(71) Applicant: MITSUBISHI HEAVY INDUSTRIES, LTD., Tokyo 108-8215 (JP)
(72) Inventor: Kobayashi, Yasuyuki,c/o MITSUBISHI HEAVY IND. Ltd, YOKOHAMA,Kanagawa (JP); Satake, Koji,c/o MITSUBISHI HEAVY IND. Ltd, YOKOHAMA,Kanagawa (JP); Sakai, Satoshi, c/o MITSUBISHI HEAVY IND. Ltd., YOKOHAMA,Kanagawa (JP)
(74) Representative: Jorio, Paolo

(57) **Abstract**

A photoelectric conversion device is composed of a substrate (1), a lower electrode layer (2) formed to cover the substrate (1), and a first semiconductor layer (3) formed on the lower electrode (2). The lower electrode layer (2) includes a first matrix (6) formed of transparent conductive material, and light scattering granules (7) embedded within the first matrix (6).

## Description

### Background of the Invention

### 1. Field of the Invention

The present invention relates to photoelectric conversion devices utilizing photoelectric effect to generate power.

### 2. Description of the Related Art

One of the issues of the photoelectric conversion device (for example, a thin film solar cell) using a semiconductor thin film for photoelectric conversion is the improvement in conversion efficiency. It is inevitable that thin-film-based photoelectric conversion devices experience reduced conversion efficiency compared to that of photoelectric conversion devices integrated in single-crystal semiconductor chips. The improvement in the conversion efficiency is one of the most important requirements for the commercial use of the thin-film-based photoelectric conversion device.

Providing a textured transparent electrode on a substrate is one of the promising techniques for improving the conversion efficiency, as disclosed in Japanese Patent Gazette No. 2862174, and Japanese Laid Open Patent Publication Nos. 2003-243676 and 2002-222975. In the photoelectric conversion device employing this technique, a semiconductor layer for photoelectric conversion is formed on the textured transparent electrode. The textured transparent electrode provide scattering of incident light for the photoelectric conversion device, and effectively improves the light absorption, that is, the conversion efficiency effectively.

Various techniques have been known for forming textured transparent electrodes. As disclosed in Patent Gazette No. 2862174, a first conventional technique employs a thermal CVD (Chemical Vapor Deposition) technique for forming the transparent electrode; a textured transparent electrode is formed through a thermal CVD technique with the growth conditions optimized. A second technique, as disclosed in Japanese Laid Open Patent Publication No. P2002-222975, involves polishing the textured surface of a glass substrate and forming the transparent electrode on the polished surface. A third technique, as disclosed in Japanese Laid Open Patent Publication No. P2003-243676, involves forming a thin film composed of insulating fine particles bound with medium on a substrate, and forming a transparent electrode to cover the thin film.

The conventional technique based on the textured transparent electrode, however, experiences limitations in the improvement in the conversion efficiency, as disclosed in Yoshiyuki Nasuno et al., "Effects of Substrate Surface Morphology On Microcrystalline Silicon Solar Cells", Jpn. J. Appl. Phys., the Japan Society of Applied Physics, 1 April 2001, vol. 40, pp. L303-L305. This difficulty results from the fact that the textured transparent electrode undesirably induces defects within the semiconductor thin film integrated thereon. Although increasing the light absorption of the semiconductor layer, the irregularities provided on the surface of the transparent electrode undesirably increase the defects within the semiconductor thin film, and cause the reduction in the output voltage of the photoelectric conversion device. Accordingly, there is a fundamental limitation in achieving improved conversion efficiency through using the textured transparent electrode.

Therefore, a need exists to provide a novel technique for improving the conversion efficiency.

### Summary of the Invention

Therefore, the present invention addresses providing a novel technique for improving the conversion efficiency of the photoelectric conversion device.

In an aspect of the present invention, a photoelectric conversion device is composed of a substrate, a lower electrode layer formed to cover the substrate, and a first semiconductor layer formed on the lower electrode. The lower electrode layer includes a first matrix formed of transparent conductive material, and light scattering granules embedded within the first matrix.

The such-designed lower electrode layer effectively scatters the incident light and thereby increases the effective optical path length within the first semiconductor layer. This effectively improves the conversion efficiency of the photoelectric conversion device.

Another advantage is that this structure eliminates the need for providing irregularities on the lower electrode layer. In other words, the structure described above allows the lower electrode layer to be substantially flat. This advantageously avoids the generation of defects within the first semiconductor layer, and thereby improves the conversion efficiency. The term "substantial flat" means the state in which the average value θ of the angle between the upper surface of the lower electrode layer and the main surface of the substrate is reduced down to 5 degrees or less, the angle being defined in any cross section having a length of 300 to 1200 nm in the direction parallel to the main surface of the substrate.

The difference between relative refractive indexes of the first matrix and the light scattering granules is preferably 2.0 or less.

It is also preferable that the light scattering granules are formed of insulating material, especially one selected form a group consisting of titanium oxide, diamond, silicon oxide, magnesium fluoride, magnesium oxide, zinc oxide, and lithium tantalate.

Preferably, the light scattering granules are composed first and second light scattering granules formed of different materials having different relative refractive indexes.

In a preferred embodiment, an average of external dimensions of the light scattering granules ranges from 60 to 2000 nm, where the light scattering granules are each approximated by an ellipsoid having a major axis, and the external dimensions are each defined as being twice the average of a distance between the major axis and a surface of associated one of the light scattering granules. It is more preferable that the average of the external dimensions of the light scattering granules is equal to or less than 1200 nm, further preferably, equal to or less than 300 nm.

When said light scattering granules are formed of structures having the center, an average of diameters of the light scattering granules preferably ranges from 60 to 2000 nm, where the diameters are each defined as being twice the average of a distance between a center and a surface of associated one of the light scattering granules. It is more preferable that the average of the diameters is equal to or less than 1200 nm, further preferably, equal to or less than 300 nm. In this case, a difference between maximum and minimum values of the diameters is preferably equal to or less than 120 nm.

An average of spacing lengths of the light scattering granules is preferably equal to or less than 4000 nm, where the spacing length of the light scattering granules is defined as being a distance between centers of adjacent two of the light scattering granules. It is more preferable that the average of the spacing lengths is equal to or less than 2400 nm.

In a preferred embodiment, a ratio δ_{AVE} /d_{AVE}, which is defined as being a ratio of a average spacing length δ_{AVE} of the light scattering granules to an average diameter d_{AVE}, is equal to or less than 20, where the average spacing length δ_{AVE} is defined as being the average of spacing lengths of the light scattering granules with the spacing lengths of the light scattering granules each defined as being a distance between centers of adjacent two of the light scattering granules, and the average diameter d_{AVE} defined as being the average of diameters of the light scattering granules, with the diameters each defined as being twice the average of a distance between a center and a surface of associated one of the light scattering granules. It is more preferable that the ratio δ_{AVE}/d_{AVE} is equal to or less than 4.

In order to enhance the light confinement within the first semiconductor layer, a distance between the light scattering granules and the contact face, on which the lower electrode layer is in contact with first semiconductor layer, is preferably equal to or less than 50 nm. It is more preferable that the distance between the light scattering granules and the contact face is equal to or less than 30 nm. In the most preferable embodiment, the light scattering granules are positioned in contact with the contact face.

When the photoelectric conversion device additionally includes an intermediate layer formed on the first semiconductor layer, and a second semiconductor layer formed on the intermediate layer, the intermediate layer preferably includes a second matrix formed of transparent conductive material, and light scattering granules embedded within the second matrix. Such structure eliminates the need for providing irregularities on the upper surface of the intermediate layer for enhancing light scattering, and thereby effectively improves the conversion efficiency avoiding defects being generated within the second semiconductor layer.

An upper electrode layer formed to cover the first semiconductor layer preferably includes a third matrix formed of transparent conductive material, and light scattering granules embedded within the third matrix; this structure effectively provides light scattering and thereby improves the conversion efficiency of the photoelectric conversion device.

In another aspect of the present invention, a photoelectric conversion device is composed of a substrate, a first semiconductor layer formed to cover an upper surface of the substrate, a second semiconductor layer formed to cover an upper surface of the first semiconductor layer, and an intermediate layer disposed between the first and second semiconductor layers. The intermediate layer includes a matrix formed of transparent conductive material, and light scattering granules embedded within the matrix.

In still another aspect of the present invention, a substrate structure used for a photoelectric conversion device is composed of a substrate, a lower electrode layer formed to cover the substrate. The lower electrode layer includes a matrix formed of transparent conductive material, and light scattering granules embedded within the matrix.

In still another aspect of the present invention, a method for fabricating a substrate structure used for a photoelectric conversion device is composed of:
covering a substrate with a first layer formed of transparent conductive material;
applying a solution containing a precursor of the transparent conductive material and light scattering granules onto the first layer; and
sintering the solution to complete a second layer on the first layer, the second layer includes a matrix and the light scattering granules embedded within the matrix.

### Brief Description of the Drawings

Fig. 1 is a sectional view showing the structure of a tandem thin-film solar cell in one embodiment of the present invention;
Fig. 2A is a graph showing the dependence of the open voltage on the flatness of the lower electrode layer and with respect to the tandem thin-film solar cell;
Fig. 2B is a diagram explaining the definition of the external dimension of an ellipsoid;
Fig. 3A is a sectional view showing a preferable fabrication process for the lower electrode layer of the tandem thin-film solar cell;
Fig. 3B is a sectional view showing the preferable fabrication process for the lower electrode layer of the tandem thin-film solar cell;
Fig. 4 is a sectional view showing the structure of the tandem thin-film solar cell of another embodiment of the present invention;
Fig. 5 is a sectional view showing the structure of the tandem thin-film solar cell of still another embodiment of the present invention;
Fig. 6 is a sectional view showing the structure of the tandem thin-film solar cell of still another embodiment of the present invention;
Fig. 7 is a sectional view showing the target structure used for the characteristics simulation;
Fig. 8A is a graph showing the dependence of the short-circuit current ratio of the top cell on the spacing length of the light scattering granules under the conditions that the light scattering granules are made of TiO₂ and the diameter thereof ranges from 60 nm to 600 nm;
Fig. 8B is a graph showing the dependence of the short-circuit current ratio of the bottom cell on the spacing length of the light scattering granules under the conditions that the light scattering granules are made of TiO₂ and the diameter thereof ranges from 60 nm to 600 nm;
Fig. 9A is a graph showing the dependence of the short-circuit current ratio of the top cell on the spacing length of the light scattering granules under the conditions that the light scattering granules are made of TiO₂ and the diameter thereof ranges from 300 nm to 1200 nm;
Fig. 9B is a graph showing the dependence of the short-circuit current ratio of the bottom cell on the spacing length of the light scattering granules under the conditions that the light scattering granules are made of TiO₂ and the diameter thereof ranges from 300 nm to 1200 nm;
Fig. 10A is a graph showing the dependence of the short-circuit current ratio of the top cell on the spacing length of the light scattering granules under the conditions that the light scattering granules are made of diamond and the diameter thereof ranges from 60 nm to 600 nm;
Fig. 10B is a graph showing the dependence of the short-circuit current ratio of the bottom cell on the spacing length of the light scattering granules under the conditions that the light scattering granules are made of diamond and the diameter ranges from 60 nm to 600 nm;
Fig. 11A is a graph showing the dependence of the short-circuit current ratio of the top cell on the ratio δ/d, where δ is the spacing length δ of the light scattering granules 7 and d is the diameter thereof;
Fig. 11B is a graph showing the dependence of the short-circuit current ratio of the bottom cell on the ratio δ/d;
Fig. 12A is a graph showing the dependence of the short-circuit current ratio of the top cell on the depth position of the light scattering granules;
Fig. 12B is a graph showing the dependence of the short-circuit current ratio of the bottom cell on the depth position of the light scattering granules; and
Fig. 13 is a sectional view showing the structure of the tandem thin-film solar cell of still another embodiment of the present invention.

### Description of the Preferred Embodiments

Preferred embodiments of the present invention will be described below in detail with reference to the attached drawings. It should be noted that the same reference numerals denote the same or like components in the drawings.

### Device Structure

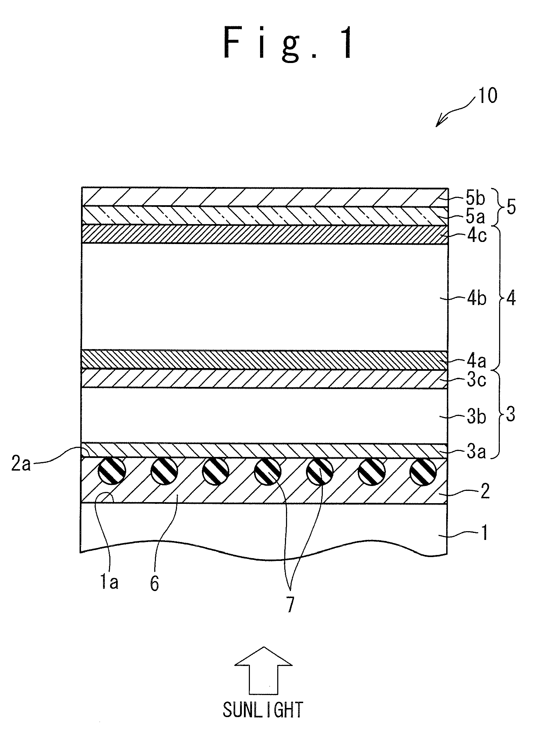

In one embodiment of the present invention, as shown in Fig. 1, a tandem thin-film solar cell 10 is provided with a glass substrate 1, a lower electrode layer 2, a top cell 3, a bottom cell 4 and an upper electrode layer 5, which are sequentially formed to cover the main surface 1a of the glass substrate 1. The top cell 3 is composed of a p-type amorphous silicon layer 3a, an i-type amorphous silicon layer 3b and an n-type amorphous silicon layer 3c, which are sequentially formed to cover the lower electrode layer 2. The bottom cell 4 is composed of a p-type microcrystalline silicon layer 4a, an i-type microcrystalline silicon layer 4b and an n-type microcrystalline silicon layer 4c, which are sequentially formed to cover the top cell 3. The upper electrode layer 5 is composed of a ZnO layer 5a formed on the bottom cell 4 and a Ag layer 5b formed on the ZnO layer 5a. The ZnO layer 5a is doped with gallium (Ga).

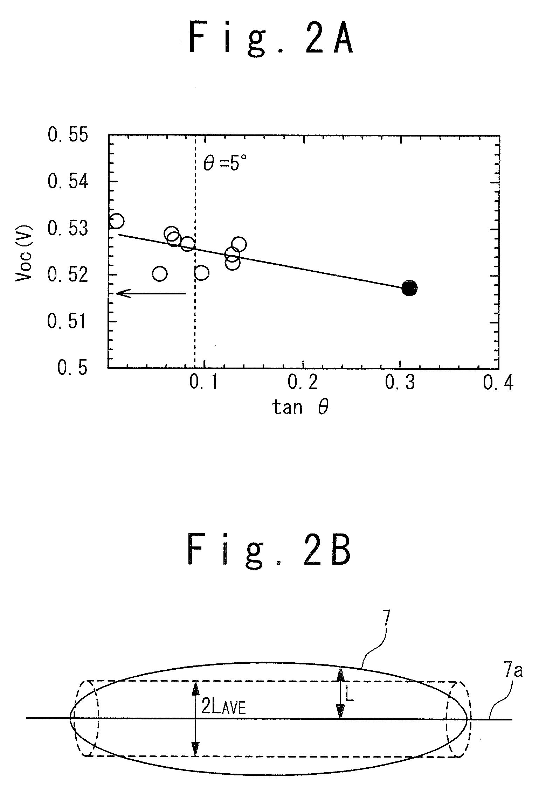

Differently from the photoelectric conversion device disclosed in the Related Art, the photoelectric conversion device in this embodiment is intended to be free from the irregularities of the lower electrode layer 2 for improving the conversion efficiency; the irregularities are not positively provided on the upper surface 2a of the lower electrode layer 2. The upper surface 2a, which is in contact with the top cell 3, is substantially flat. The term "substantial flat" means the state in which the average value θ of the angle between the upper surface 2a of the lower electrode layer 2 and the main surface 1a of the glass substrate 1 is reduced down to 5 degrees or less, the angle being defined in any cross section having a length of 300 to 1200 nm in the direction parallel to the main surface 1a of the glass substrate 1. Flatly forming the lower electrode layer 2 effectively avoids the reduction in the open voltage resulting from the defects of the silicon layer. Fig. 2 is a graph for ensuring this, illustrating the dependence of the open voltage on the average value θ. As will be understood from Fig. 2, when the average value θ is 5 degrees or less, the open voltage is not reduced.

Instead of being provided with irregularities, as shown in Fig. 1, the lower electrode layer 2 is composed of a matrix 6 formed of transparent conductive material, and light scattering granules 7 embedded in the matrix 6. The light scattering granules 7 scatters light incident from the rear surface of the glass substrate 1, and enhances the light absorption within the top cell 3 and bottom cell 4. In other words, the use of the lower electrode layer 2, in which the light scattering granules 7 are buried in the matrix 6, eliminates the need for providing irregularities on the surface of the lower electrode layer 2 for scattering the incident lights. This effectively improves the conversion efficiency while suppressing the generation of the defects of the semiconductor layers constituting the top cell 3 and the bottom cell 4.

A detailed description of preferred structure and physical properties of the matrix 6 and light scattering granules 7 is given in the following.

The matrix 6 may be formed of a commonly used transparent conductive material, such as tin oxide, zinc oxide, indium oxide and ITO (Indium Tin Oxide).

The light scattering granules 7 are formed of a material having a relative refractive index different from that of the matrix 6. The light scattering granules 7 are preferably formed of a material having a relative refractive index different by 2 or less from that of the matrix 6. Specifically, for the case when the matrix 6 is made of one material selected out of tin oxide, zinc oxide, indium oxide, and ITO, the light scattering granules 7 are preferably formed of one selected out of a group consisting of titanium oxide, diamond, SiO₂ or glass, MgF₂, MgO, ZnO, and LiTaO₃; it should be noted that titanium oxide has a relative refractive index of 2.2 to 2.3, diamond has a relative refractive index of 2.1 to 2.2, SiO₂ or glass has a relative refractive index of 1.53, MgF₂ has a relative refractive index of 1.29, MgO has a relative refractive index of 1.73, ZnO has a relative refractive index of 1.88, and LiTaO₃ has a relative refractive index of 2.18.

The light scattering granules 7 need not to be formed of conductive material; forming the light scattering granules 7 of insulating material, which includes a reduced number of free electrons, is rather preferable for reducing the light absorption by the light scattering granules 7. It should be noted that the use of the insulator as the light scattering granules 7 does not hinder the flow of the photoelectric current, because the photoelectric current generated by the top cell 3 and the bottom cell 4 flows via the matrix 6.

The size of the light scattering granules 7 is one of the important parameters for improving the scattering efficiency of the incident light. When the shape of each light scattering granule 7 is approximated by an ellipsoid as shown in Fig. 2B, the average of the external dimensions of the light scattering granules 7 preferably ranges from 60 nm to 2000 nm, and more preferably from 60 nm to 1200 nm; the external dimension of each light scattering granule 7 is defined as being twice the average L_{AVE} of the distance L between the major axis 7a of the light scattering granule 7 and the surface thereof.

For the case that the light scattering granules 7 are formed of structures having a center, such as the sphere and the regular polyhedron, the average diameter of the light scattering granules 7 ranges preferably from 10 nm to 2000 nm, and more preferably from 60 nm to 1200 nm; the diameter of a certain light scattering granule 7 is defined as being twice the average of the distance between the center of the light scattering granule 7 and the surface thereof, and the average diameter means the average of the diameters of the light scattering granules 7 defined as described above. Designing the light scattering granules 7 to have an average diameter selected from this range effectively improves the scattering efficiency for light having wavelengths used for generation of electric power, and thus effectively improves the conversion efficiency of the tandem thin-film solar cell 10.

In addition, the average spacing length of the light scattering granules 7 is preferably 4000 nm or less; the spacing length between the adjacent light scattering granules 7 means the distance between the centers of the light scattering granules 7, and the average spacing length means the average of the spacing lengths of the light scattering granules 7. More preferably, the average spacing length of the light scattering granules 7 is 2400 nm or less, which is the range defined as being equal to or less than twice the upper limit (1200 nm) of the light wavelength range used for generation of electric power. Arranging the light scattering granules 7 to be spaced with the spacing length selected from this range effectively improves the scattering efficiency for light having wavelengths used for generation of electric power, and thus effectively improves the conversion efficiency of the tandem thin-film solar cell 10.

The ratio δ_{AVE}/d_{AVE}, which is defined as being the ratio of the average spacing length δ_{AVE} of the light scattering granules 7 to the average diameter d_{AVE}, is preferably 20 or less, and more preferably 4 or less. Arranging the light scattering granules 7 to satisfy this requirement effectively improves the scattering efficiency for light having wavelengths used for generation of electric power, and thus effectively improves the conversion efficiency of the tandem thin-film solar cell 10.

The distance between the upper surface 2a of the lower electrode layer 2 in the side of the top cell 3 and the light scattering granules 7, which may be referred to as the depth of the light scattering granules 7, is preferably less than 50 nm, more preferably less than 30 nm. It is most preferable that the light scattering granules 7 are positioned in contact with the upper surface 2a; an exemplary structure where the light scattering granules 7 comes into contact with the upper surface 2a is shown in Fig. 1. Reducing the distance between the upper surface 2a and the light scattering granules 7 promotes the light confinement within the top cell 3 and the bottom cell 4, and effectively improves the conversion efficiency of the tandem thin-film solar cell 10.

The light scattering granules 7 are preferably arranged as regularly as possible. More specifically, it is preferable that the difference between the maximum value and minimum value of the depths of the light scattering granules 7 (which is defined as being the distance between the upper surface 2a and the light scattering granules 7) is reduced down to 30 nm or less, that is, 1/10 or less of the lower limit (300 nm) of the light wavelength range used for the generation of electric power.

For the case when the light scattering granules 7 are each approximated by an ellipsoid as shown in Fig. 2B, the difference between the maximum value and minimum value of the external dimensions of the light scattering granules 7 is preferably 120 nm or less, that is, 1/10 or less of the upper limit (1200 nm) of the light wavelength range used for the generation of electric power. Correspondingly, for the case when the light scattering granules 7 are formed of structures having each center, it is preferable that the difference of the maximum value and minimum value of the diameters of the light scattering granules 7 is 120 nm or less. Since the influence of variations in the size of the light scattering granules 7 on the conversion efficiency is smaller than that of the depths of the light scattering granules 7, the diameters of the light scattering granules 7 are allowed to exhibit larger variation as compared with the depths of the light scattering granules 7. Similarly, the difference between the maximum value and minimum value of the spacing lengths of the light scattering granules 7 is preferably 120 nm or less.

The lower electrode layer 2, in which the light scattering granules 7 are embedded in the matrix 6, is preferably formed through a CVD technique, a sputtering technique, an ion plating technique, or a sol-gel technique at a previous stage, and through a sol-gel technique at a latter stage. When a sol-gel technique is used at the latter stage, the light scattering granules 7 are preferably mixed in a precursor solution of the matrix 6 before applying the precursor solution onto the glass substrate 1; this effectively facilitates the homogeneous dispersion of the light scattering granules 7 across the matrix 6.

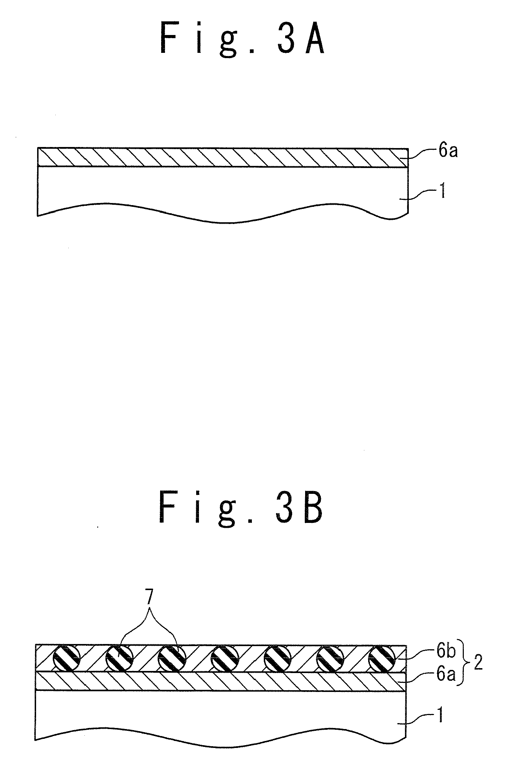

Figs. 3A and 3B are sectional views showing a preferable formation process of the lower electrode layer 2. First, as shown in Fig. 3A, a first layer 6a, made of the same material as that of the matrix 6, is formed on the main surface 1a of the glass substrate 1 through a technique selected out of a CVD technique, a sputtering technique, an ion plating technique and a sol-gel technique. In one embodiment, the first layer 6a may be directly formed through a CVD technique, a sputtering technique or an ion plating technique. Alternatively, the first layer 6a may be formed through a sol-gel technique, which involves applying a solution containing a precursor of the matrix 6 onto the glass substrate 1, and sintering the precursor solution. It is advantageous that the first layer 6a is formed through a technique selected out of a CVD technique, a sputtering technique, an ion plating technique, because experience shows that the use of a CVD technique, a sputtering technique, and an ion plating technique effectively improves the performance of the matrix 6 compared to a sol-gel technique.

A second layer 6b is then formed through a sol-gel technique. In detail, a solution of the precursor of the matrix 6 mixed with the light scattering granules 7 is applied onto the glass substrate 1, and the precursor solution is then sintered to complete the second layer 6b.

This fabrication process achieves forming such a structure that the light scattering granules 7 are located near the upper surface 2a of the lower electrode layer 2 the lower electrode layer 2. The light scattering granules 7 can be ideally positioned in contact with the upper surface 2a by forming the second layer 6b to have a thickness equal to the diameter of the light scattering granules 7 through appropriately adjusting the viscosity of the precursor solution used for forming the second layer 6b.

### Preferred Variations

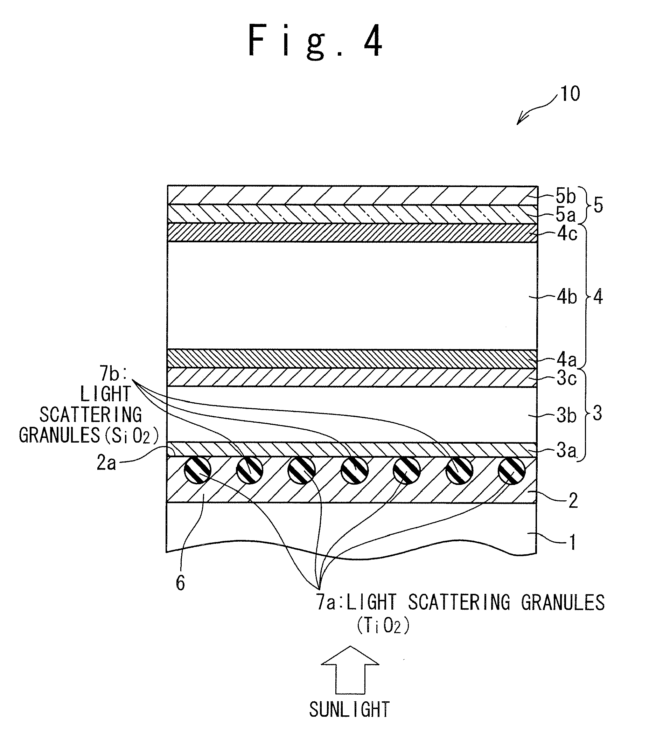

In order to scatter the incident light more effectively, the lower electrode layer 2 is preferably designed so that the light scattering granules 7 are formed of different materials having different refractive indexes; such a structure is easily achieved through using a sol-gel technique for depositing the lower electrode layer 2. In a preferred embodiment, as shown in Fig. 4, the light scattering granules 7 may include light scattering granules 7a made of titanium oxide and light scattering granules 7b made of SiO₂ (or glass). This effectively reduces the probability that two or more light scattering granules 7 having the same relative refractive index are positioned in contact with each other, and thereby improves the scattering efficiency of the incident light.

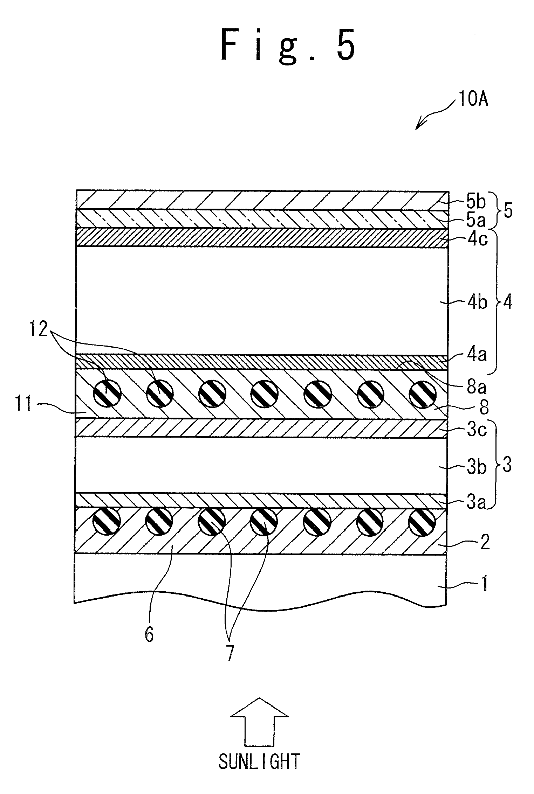

When an intermediate layer is provided between the top cell 3 and the bottom cell 4, the light scattering granules are preferably embedded within the intermediate layer. Fig. 5 is a sectional view showing an exemplary structure of such designed tandem thin-film solar cell 10A. The tandem thin-film solar cell 10A is provided with an intermediate layer 8 provided between the top cell 3 and the bottom cell 4. The upper surface 8a of the intermediate layer 8, which is in contact with the bottom cell 4 is formed to be "substantially flat", and the intermediate layer 8 is composed a matrix 11 formed of transparent conductive material and light scattering granules 12 embedded within the matrix 11. The light incident from the intermediate layer 8 into the bottom cell 4 is sufficiently scattered by embedding the light scattering granules 12 in the intermediate layer 8, and the scattering of the incident light effectively increases the optical path length of the transmitting light within the bottom cell 4. This effectively enhances the light absorption within the bottom cell 4. In addition, embedding the above-described structure, in which the light scattering granules 12 are embedded within the matrix 11, eliminates the need for providing the irregularities on the upper surface 8a of the intermediate layer 8 for improving the conversion efficiency; embedding the light scattering granules 12 within the matrix 11 allows the upper surface 8a of the intermediate layer 8 to be substantially flat; the term "substantially flat" means the same as the definition given above. Flatly forming the intermediate layer 8 is effective for improving the conversion efficiency of the bottom cell 4; this effectively suppresses the generation of the defects within the p-type microcrystalline silicon 4a, the i-type microcrystalline silicon layer 4b and the n-type microcrystalline silicon layer 4c, formed sequentially on the surface 8a, and thereby improves the conversion efficiency of the bottom cell 4.

Preferred physical properties of the matrix 11 and light scattering granules 12 of the intermediate layer 8 are the same as those of the matrix 6 and light scattering granules 7 within the lower electrode layer 2. The matrix 11 may be formed of a commonly used transparent conductive material, such as tin oxide, zinc oxide, indium oxide, and ITO (Indium Tin Oxide). The light scattering granules 12 may be formed of a material having a relative refractive index different from that of the matrix 11, such as, titanium oxide, diamond, SiO₂ (or glass), MgF₂, MgO, ZnO, and LiTaO₃. The light scattering granules 12 need not to be formed of conductive material.

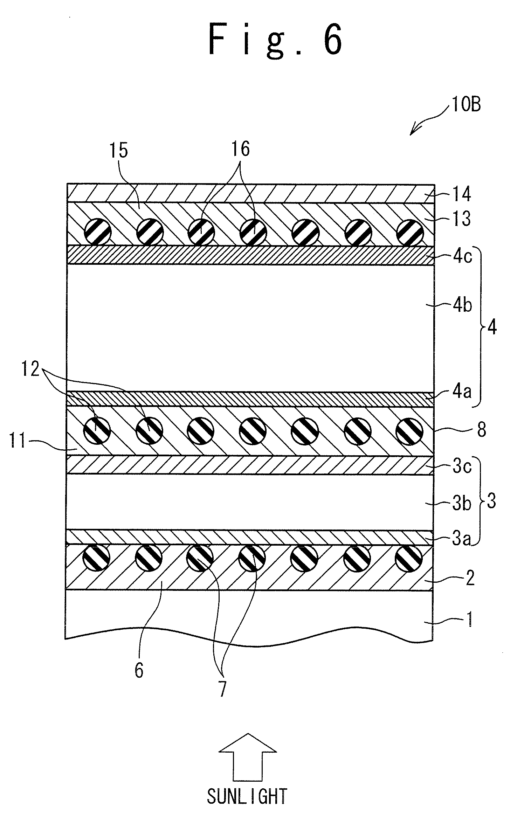

It is also preferable that light scattering granules are embedded in the upper electrode layer. Fig. 6 is a sectional view showing an exemplary structure of a such-designed tandem thin-film solar cell 10B. The tandem thin-film solar cell 10B is provided with a transparent electrode 13 formed on the bottom cell 4 and an Ag layer 14 formed on the transparent electrode 13 instead of the upper electrode layer 6 shown in Fig. 1; the transparent electrode layer 13 and the Ag layer 14 function as the upper electrode of the tandem thin-film solar cell 10B. The transparent electrode layer 13 is composed of a matrix 15 and light scattering granules 16 embedded in the matrix 15.

Preferred physical properties of the matrix 15 and the light scattering granules 16 of the transparent electrode layer 13 are the same as those of the matrix 6 and the light scattering granules 7 of the lower electrode layer 2. The matrix 15 may be formed of a commonly used transparent conductive material, such as, tin oxide, zinc oxide, indium oxide, and ITO (Indium Tin Oxide). The light scattering granules 16 may be formed of a material having a relative refractive index different from that of the matrix 15, such as, titanium oxide, diamond, SiO₂ (glass), MgF₂, MgO, ZnO, and LiTaO₃. The light scattering granules 16 need not be formed of conductive material.

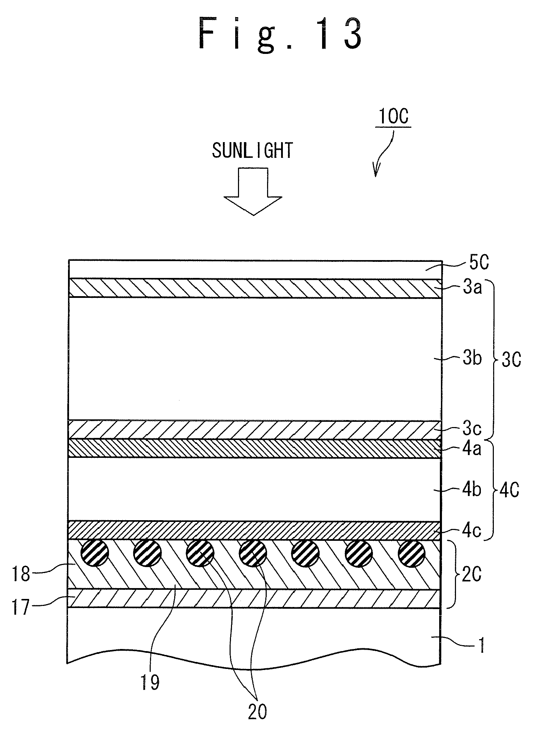

The present invention is also applicable to a thin film solar cell having such a structure that sunlight is incident from the upper electrode. Fig. 13 is a sectional view showing an exemplary structure of a such-designed tandem thin-film solar cell 10C. The thin film solar cell 10C is provided with a glass substrate 1, a lower electrode layer 2C, a bottom cell 4C, a top cell 3C, and an upper electrode layer 5C. The bottom cell 4C is composed of an n-type microcrystalline silicon layer 4c, an i-type microcrystalline silicon layer 4b, and a p-type microcrystalline silicon layer 4a, which are formed sequentially on the lower electrode layer 2C. The top cell 3C is composed of an n-type amorphous silicon layer 3c, an i-type amorphous silicon layer 3b, and a p-type amorphous silicon layer 3a, which are formed sequentially on the bottom cell 4C. The upper electrode layer 5C is made of a commonly used transparent conductive material, such as tin oxide, zinc oxide, indium oxide and ITO (Indium Tin Oxide).

The lower electrode layer 2C is composed of a metal electrode layer 17 and a transparent electrode layer 18 formed thereon. As is the case of the tandem thin-film solar cell 10 shown in Fig. 1, irregularities are not positively provided on the upper surface of the transparent electrode layer 18. Instead of being provided with irregularities, the transparent electrode layer 18 is composed of a matrix 19 formed of transparent conductive material, and light scattering granules 20 embedded within the matrix 19. The light scattering granules 20 scatter sunlight incident from the upper electrode layer 5C, and thereby promote the light absorption within the top cell 3C and bottom cell 4C. This structure effectively improves the conversion efficiency while suppressing the generation of the defects within the top cell 3C and the bottom cell 4C.

An intermediate layer may be additionally provided for the tandem thin-film solar cell 10C shown in Fig. 13. In this case, it is preferable that the intermediate layer is composed of a matrix and light scattering granules, in the same manner as the tandem thin-film solar cell 10A shown in Fig. 5. In addition, it is preferable that the upper electrode layer 5C is composed of a matrix and light scattering granules.

It should be noted that the present invention is also applicable to the thin film solar cells having various structures other than the above-described structures. For example, the structures of the upper and lower electrodes, composed of a matrix and light scattering granules, are each applicable to thin film solar cells adopting a structure other than the tandem solar cell structure.

It should be also noted that the thin film solar cell is formed of a material other than silicon; the thin film solar cell may be based on SiC or SiGe.

### Simulation Results

Hereinafter, a description is made of the effectiveness of the photoelectric conversion device according to the present invention.

The effectiveness of the tandem thin-film solar cell 10 having the structure shown in Fig. 1 was verified by simulation. The simulation was performed by directly solving Maxwell's electromagnetic equations through a Finite Difference Time Domain analysis technique (FDTD). The details of the calculation conditions of the FDTD analysis are as follows: The incident light is assumed to be a plane wave having a surface wave front parallel with the substrate surface; that is, the substrate is assumed to be straightly faced toward the sun. A Berenger's Perfect Matching Layer technique (see J. P. Berenger, J. Computational Physics, 114, 185 (1994)) is used as the algorism for determining the absorption boundaries. The time change of the amplitude of the reflected wave and that of the electromagnetic wave in each cell are recorded for the entire calculated time, the amplitudes are determined through a Fourier transformation at intervals of 5 nm over the range from 300 nm to 1200 nm (wavelength in air or a vacuum). The convergence of calculation of the absorptivity of silicon was confirmed on the basis of the fact that the sum of the absorptivity and reflectance is determined as being 100%. The quantum efficiency spectra of the top cell 3 and bottom cell 4 are obtained by this calculation. A product of the density of photons within standard sunlight (described in JIS C8911) in respective wavelengths within the range from 300 nm to 1200 nm (wavelength in air or in vacuum) and the quantum efficiency spectrum of each cell is integrated with respect to the wavelength, and the total density of absorbed photons is defined as being the short-circuit current density. This assumption is appropriate in practical solar cells, which include reduced defects within the photoelectric conversion layers.

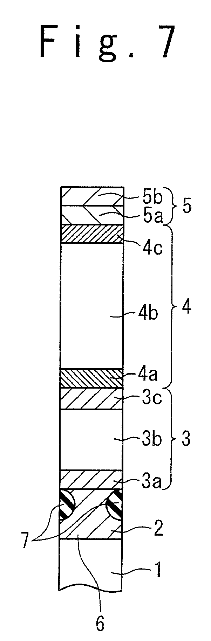

Fig. 7 shows the sectional view of the simulated structure. The simulation is performed under the assumption that the light scattering granules 7 are formed of spherical bodies, having the same diameter; this implies that the average diameter of the light scattering granules 7 is identical to the diameter of each light scattering granule 7. An additional assumption is that the structure shown in Fig. 7 is infinitely repeated in the plane direction of the glass substrate 1. In other words, the average spacing length of the light scattering granules 7 is identical to the spacing length of any two adjacent light scattering granules 7. It is also assumed that the matrix 6 of the lower electrode 2 is formed of SnO₂ doped with fluoride. Finally, it is assumed that the light scattering granules 7 are positioned in contact with the upper surface 2a of the lower electrode layer 2.

It should be noted that the thickness of the top cell 3 is selected from a range between 0.1 and 0.5 µm, and the thickness of the bottom cell 4 is selected from a range between 1 and 5 µm. It should be also noted that the thickness of the ZnO layer 5a is selected from a range between 20 and 200nm, and the thickness of the Ag layer 5b is selected from a range between 0.1 and 10 µm.

Furthermore, the short-circuit currents of the tandem thin-film solar cell 10 are represented in short-circuit current ratios (%), respectively, the short-circuit current ratios (%) are obtained by normalizing the short-circuit currents of the tandem thin-film solar cell 10 with the corresponding short-circuit currents of a top cell and a bottom cell of a tandem thin-film solar cell formed on a flat TCO (transparent conductive oxide) substrate. The fact that a short-circuit current ratio exceeds 100% implies that the device structure provides effective light scattering within the tandem solar cell. We believe that the argument based the short-circuit currents is well-founded; a similar argument is given in the aforementioned document by Yoahiyuki Nasuno et al., which addresses evaluation of textured transparent electrodes "Asahi-U™", which are manufactured by Asahi Glass Co., Ltd.

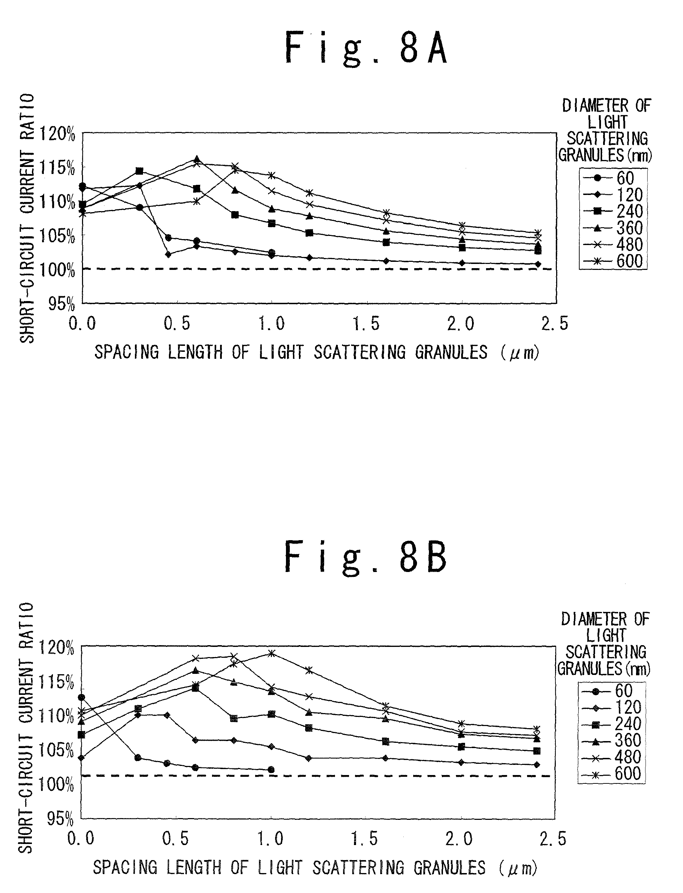

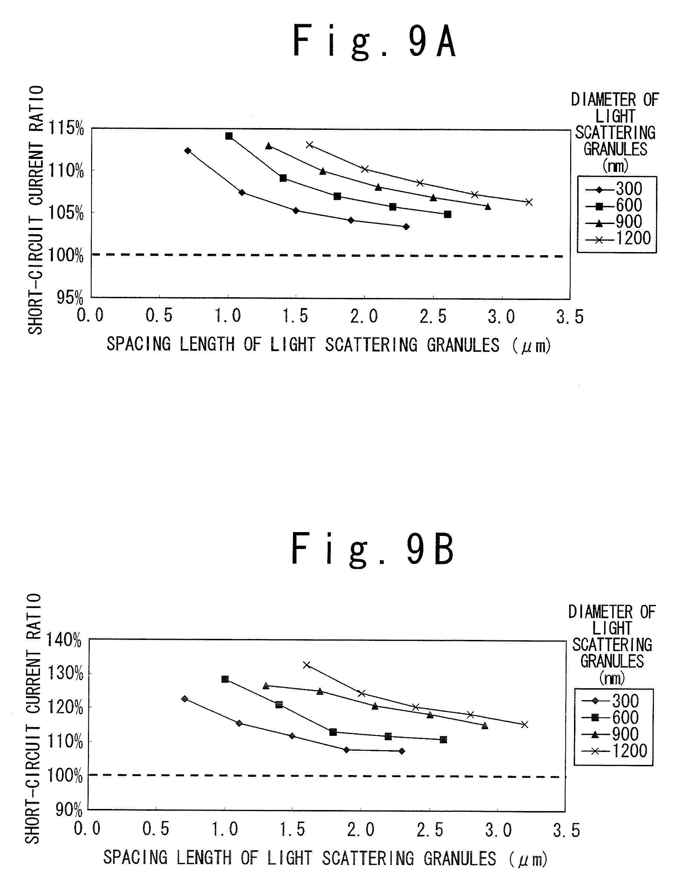

Figs. 8A, 8B, 9A and 9B are graphs illustrating the dependence of the short-circuit current ratios of the tandem thin-film solar cell 10 on the spacing length and diameter of the light scattering granules 7 with the light scattering granules 7 formed of TiO₂. In detail, Fig. 8A illustrates the dependence of the short-circuit current ratio of the top cell 3 on the spacing length of the light scattering granules 7 for the case that the diameter of the light scattering granules 7 ranges from 60 nm to 600 nm, while Fig. 8B illustrates the dependence of the short-circuit current ratio of the bottom cell 4 on the spacing length of the light scattering granules 7 for the case that the diameter of the light scattering granules 7 is in the same range. The results shown in Figs. 8A and 8B are obtained with an assumption that the film thickness of the lower electrode layer 2 is 0.7 µm.

Fig. 9A, on the other hand, illustrates the dependence of the short-circuit current ratio of the top cell 3 on the spacing length of the light scattering granules 7, for the case that the diameter of the light scattering granules 7 ranges from 300 nm to 1200 nm. Correspondingly, Fig. 9B illustrates the dependence of the short-circuit current ratio of the bottom cell 4 on the spacing length of the light scattering granules 7 for the case that the diameter of the light scattering granules 7 is in the same range. The results shown in Figs. 9A and 9B are obtained with an assumption that the film thickness of the lower electrode layer 2 is 1.2 µm.

It should be also noted that the short-circuit current ratios for the spacing length being "0 nm" in Figs. 8A, 8B, 9A and 9B correspond to short-circuit current ratios of tandem thin-film solar cells having such a structure that the light scattering granules 7 are removed from the lower electrode layer 2 and a continuous TiO₂ layer is provided between the top cell 3 and the lower electrode layer 2.

As will be understood from Figs. 8A, 8B, 9A and 9B, the short-circuit current ratio exceeding 100% can be obtained for both the top cell 3 and the bottom cell 4 when the diameter of the light scattering granules 7 ranges from 60 nm to 1200 nm with the light scattering granules 7 spaced at a spacing length of 2400 nm or less, that is, at a spacing length of twice or less of the upper limit (1200 nm) of the light wavelength range used for power generation. This implies that the above-described arrangement of the light scattering granules 7 is effective for improving the conversion efficiency.

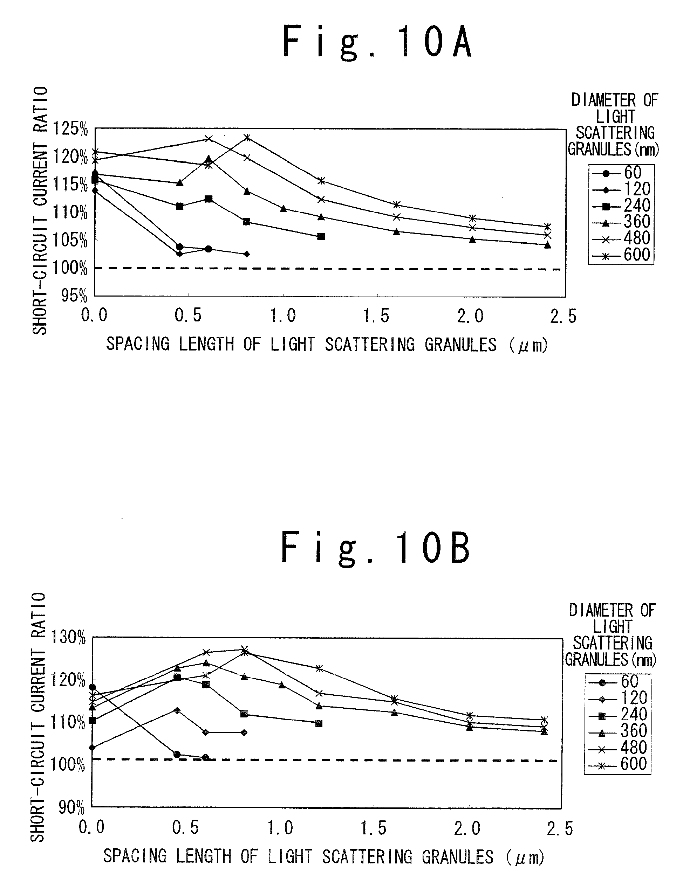

This is also the case when the light scattering granules 7 are formed of diamond. Figs. 10A and 10B are graphs illustrating the dependence of short-circuit current ratios of the tandem thin-film solar cell 10 on the spacing length and diameter of the light scattering granules 7 with the light scattering granules 7 formed of diamond; the film thickness of the lower electrode layer 2 is assumed to be 0.7 µm. In detail, Fig. 10A illustrates the dependence of the short-circuit current ratio of the top cell 3 on the spacing length of the light scattering granules 7 for the case when the diameter of the light scattering granules 7 ranges from 60 nm to 600 nm, while Fig. 10B illustrates the dependence of the short-circuit current ratio of the bottom cell 4 on the spacing length of the light scattering granules 7 for the case when the diameter of the light scattering granules 7 is in the same range.

As will be understood from Figs. 10A and 10B, the behaviors of the short-circuit current ratios of the top cell 3 and the bottom cell 4 with the light scattering granules 7 formed of diamond is similar to those of the short-circuit current ratios of the top cell 3 and the bottom cell 4 with the light scattering granules 7 formed of TiO₂. This implies that diamond can be employed as the material of the light scattering granules 7 in place of titanium oxide.

It should be noted that the discussions given for Figs. 8A, 8B, 9A, 9B, 10A and 10B are also applied to the case that the light scattering granules 7 are each approximated by an ellipsoid. When the light scattering granules 7 are each approximated by an ellipsoid (especially, when the major axis has a length of 2000 nm or more), the light scattering performance of the light scattering granules 7 is determined by the size of the light scattering granules 7 in the direction of the short axis. Therefore, the data shown in Figs, 8A, 8B, 9A, 9B, 10A and 10B provide a basis of the effectiveness of designing the light scattering granules 7 to have an external dimension ranging from 60 nm to 1200 nm; as described above, the external dimension of the light scattering granules 7 is defined as twice the average distance L_{AVE} between the major axis 7a of the light scattering granules 7 and the surface thereof.

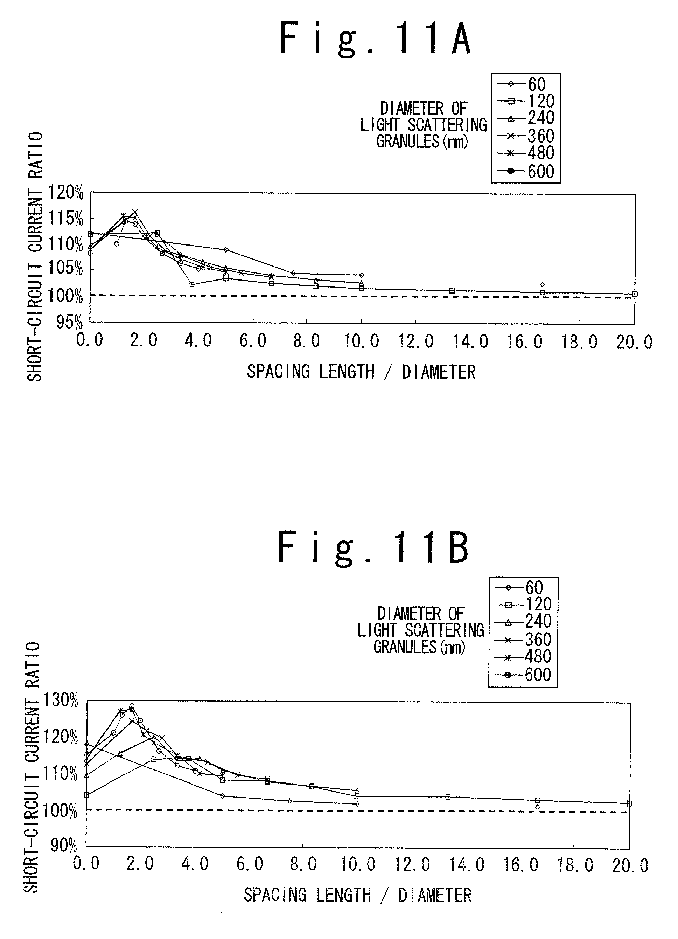

Figs. 11A and 11B show the dependence of the short-circuit current ratios of the tandem thin-film solar cell 10 on the ratio δ/d, which is defined as being the ratio of the spacing length δ to the diameter d of the light scattering granules 7. In detail, Fig. 11A shows the dependence of the short-circuit current ratio on the ratio δ/d for the top cell 3, while Fig. 11B shows that for the bottom cell 4. It is assumed that the diameter of the light scattering granules 7 ranges from 60 nm to 600 nm. With respect to both the top cell 3 and the bottom cell 4, the short-circuit current ratios exceeding 100% are obtained for the ratio δ/d of 20 or less as long as the diameter of the light scattering granules 7 exceeds 60 nm.

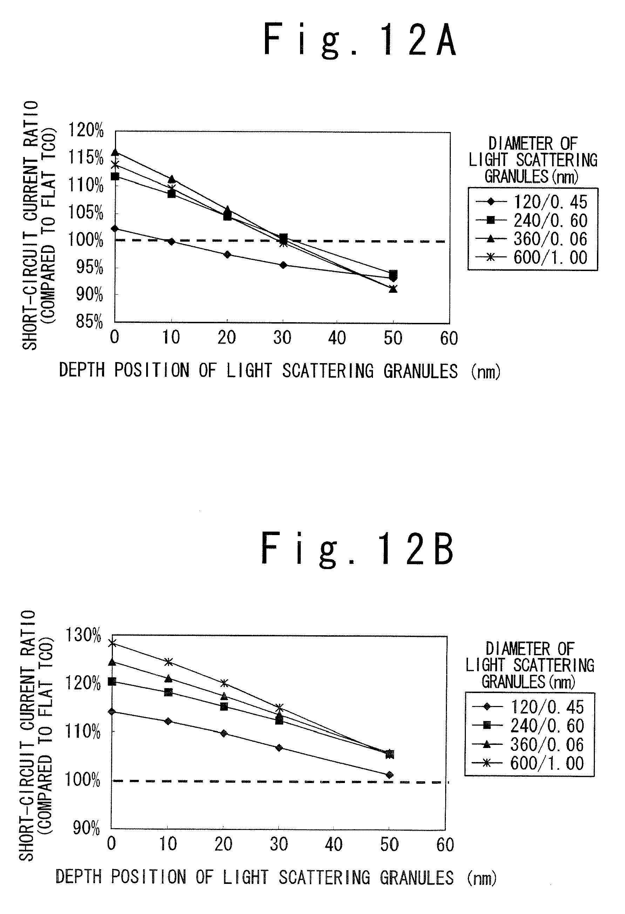

Figs. 12A and 12B show the dependence of the short-circuit current ratios on the depth of the light scattering granules 7, that is, the distance between the light scattering granules 7 and the upper surface 2a of the lower electrode layer 2. In detail, Fig. 12A shows the dependence of the short-circuit current ratio on the depth of the light scattering granules 7 for the top cell 3, while Fig. 12B shows that for the bottom cell 4. The diameter of the light scattering granules 7 is selected from 120 nm, 240 nm, 360 nm and 600 nm, and the spacing length is selected so that the short-circuit current is set to the maximum for each diameter.

As will be understood from Figs. 12A and 12B, the short-circuit current ratios increase as the decrease in the depth of the light scattering granules 7. For the top cell 3, the short-circuit current ratio exceeding 100% is obtained by reducing the depth of the light scattering granules 7 down to 30 nm or less, as shown in Fig. 12A. For the bottom cell 4, the short-circuit current ratio exceeding 100% is obtained by reducing the depth of the light scattering granules 7 down to 50 nm or less, as shown in Fig. 12B, As shown in Figs. 12A and 12B, it is preferable that the depth of the light scattering granules 7 is down to 50 nm or less, more preferably down to 30 nm or less.

Although the invention has been described in its preferred form with a certain degree of particularity, it is understood that the present disclosure of the preferred form has been changed in the details of construction and the combination and arrangement of parts may be resorted to without departing from the scope of the invention as hereinafter claimed.

## Claims

1. A photoelectric conversion device comprising:
a substrate (1);
a lower electrode layer (2)(2C) formed to cover said substrate (1); and
a first semiconductor layer (3)(4C)formed on said lower electrode layer (2)(2C),
wherein said lower electrode layer (2)(2C) includes:
a first matrix (6)(19) formed of transparent conductive material, and
light scattering granules (7)(20) embedded within said first matrix (6)(19).

2. The photoelectric conversion device according to claim 1, wherein said lower electrode layer (2)(2C) is in contact with said first semiconductor layer (3)(4C) on a contact face (2a), and
wherein said contact face (2a) is substantially flat.

3. The photoelectric conversion device according to claim 2, wherein a difference between relative refractive indexes of said first matrix (6) and second light scattering granules (7) is 2.0 or less.

4. The photoelectric conversion device according to claim 2, wherein said light scattering granules (7) are formed of insulating material.

5. The photoelectric conversion device according to claim 2, wherein said light scattering granules (7) are formed of one selected form a group consisting of titanium oxide, diamond, silicon oxide, magnesium fluoride, magnesium oxide, zinc oxide, and lithium tantalate.

6. The photoelectric conversion device according to claim 2, wherein said light scattering granules (7) comprises:
first and second light scattering granules (7a, 7b) formed of different materials having different relative refractive indexes.

7. The photoelectric conversion device according to claim 2, wherein an average of external dimensions of said light scattering granules (7) ranges from 60 to 2000 nm, where said light scattering granules (7) are each approximated by an ellipsoid having a major axis, and said external dimensions are each defined as being twice the average of a distance between said major axis and a surface of associated one of said light scattering granules (7).

8. The photoelectric conversion device according to claim 2, wherein said average of said external dimensions of said light scattering granules (7) is equal to or less than 1200 nm.

9. The photoelectric conversion device according to claim 2, wherein said average of said external dimensions of said light scattering granules (7) is equal to or more than 300 nm.

10. The photoelectric conversion device according to claim 2, wherein an average of diameters of said light scattering granules (7) ranges from 60 to 2000 nm, where said diameters are each defined as being twice the average of a distance between a center and a surface of associated one of said light scattering granules (7).

11. The photoelectric conversion device according to claim 10, wherein said average of said diameters is equal to or less than 1200 nm.

12. The photoelectric conversion device according to claim 10, wherein said average of said diameters is equal to or more than 300 nm.

13. The photoelectric conversion device according to claim 10, wherein a difference between maximum and minimum values of said diameters is equal to or less than 120 nm.

14. The photoelectric conversion device according to claim 2, wherein an average of spacing lengths of said light scattering granules (7) is equal to or less than 4000 nm, where said spacing lengths of said light scattering granules (7) are each defined as being a distance between centers of adjacent two of said light scattering granules (7).

15. The photoelectric conversion device according to claim 14, wherein said average of said spacing lengths is equal to or less than 2400 nm.

16. The photoelectric conversion device according to claim 2, wherein a ratio δ_{AVE} / d_{AVE}, which is defined as being a ratio of a average spacing length δ_{AVE} of said light scattering granules (7) to an average diameter d_{AVE}, is equal to or less than 20, where said average spacing length δ_{AVE} is defined as being the average of spacing lengths of said light scattering granules (7) with said spacing lengths of said light scattering granules (7) each defined as being a distance between centers of adjacent two of said light scattering granules (7), and said average diameter d_{AVE} defined as being the average of diameters of said light scattering granules (7), with said diameters each defined as being twice the average of a distance between a center and a surface of associated one of said light scattering granules (7).

17. The photoelectric conversion device according to claim 16, wherein said ratio δ_{AVE}/d_{AVE} is equal to or less than 4.

18. The photoelectric conversion device according to claim 14, wherein a difference between maximum and minimum values of said spacing lengths is equal to or less than 120 nm.

19. The photoelectric conversion device according to claim 2, wherein a distance between said light scattering granules (7) and said contact face (2a) is equal to or less than 50 nm.

20. The photoelectric conversion device according to claim 2, wherein a distance between said light scattering granules (7) and said contact face (2a) is equal to or less than 30 nm.

21. The photoelectric conversion device according to claim 2, wherein said light scattering granules (7) are positioned in contact with said contact face (2a).

22. The photoelectric conversion device according to claim 1, further comprising:
an intermediate layer (8) formed on said first semiconductor layer (3); and
a second semiconductor layer (4) formed on said intermediate layer (8),
wherein said intermediate layer (8) includes:
a second matrix (11) formed of transparent conductive material, and
light scattering granules (12) embedded within said second matrix (11).

23. The photoelectric conversion device according to claim 22, wherein said intermediate layer (8) is in contact with said second semiconductor layer (4) on another contact face, and
wherein said another contact face (8a) is substantially flat.

24. The photoelectric conversion device according to claim 1, further comprising:
an upper electrode layer (13) formed to cover said first semiconductor layer (3),
wherein said upper electrode layer (13) includes:
a third matrix (15) formed of transparent conductive material, and
light scattering granules (16) embedded within said third matrix (15).

25. The photoelectric conversion device according to claim 1, wherein said first semiconductor layer (3)(4C) is formed on selected from a group consisting of silicon, SiC, and SiGe.

26. A photoelectric conversion device comprising:
a substrate (1);
a first semiconductor layer (3) formed to cover an upper surface of said substrate (1);
a second semiconductor layer (4) formed to cover an upper surface of said first semiconductor layer (3); and
an intermediate layer (8) disposed between said first and second semiconductor layers (3, 4),
wherein said intermediate layer (8) includes:
a matrix (11) formed of transparent conductive material, and
light scattering granules (12) embedded within said matrix.

27. A substrate structure used for a photoelectric conversion device, said substrate structure comprising:
a substrate (1); and
a lower electrode layer (2)(2C) formed to cover said substrate (1),
wherein said lower electrode layer (2)(2C) includes:
a matrix (6) formed of transparent conductive material, and
light scattering granules (7) embedded within said matrix (6).

28. A method for fabricating a substrate structure used for a photoelectric conversion device, said method comprising:
covering a substrate (1) with a first layer (6a) formed of transparent conductive material;
applying a solution containing a precursor of said transparent conductive material and light scattering granules (7) onto said first layer (6a); and
sintering said solution to complete a second layer (6b) on said first layer (6a) so that said second layer (6b) includes a matrix and said light scattering granules (7) embedded within said matrix.
